# EUROPEAN PATENT SPECIFICATION

(11) **EP 0 392 725 B1**
(45) Date of publication and mention of the grant of the patent: **09.11.1994**
(21) Application number: 90303551.7
(22) Date of filing: 03.04.1990
(51) Int. Cl.: H01L 21/285, H01L 23/485, H01L 21/90, H01L 21/3205

(54) **Method for fabricating integrated circuits with silicide**
Verfahren zum Herstellen von integrierten Schaltungen mit Silizid
Procédé de fabrication de circuits intégrées avec siliciure

(30) Priority: 11.04.1989 US 336382
(43) Date of publication of application: 17.10.1990
(73) Proprietor: AT&T Corp., New York, NY 10013-2412 (US)
(72) Inventor: Liu, Ruichen, Warren, New Jersey 07060 (US); Lu, Chih-Yuan, Wescosville, Pennsylvania 18106 (US); Pai, Chien-Shing, Bridgewater, New Jersey 08807 (US); Tsai, Nun-Sian, Allentown, Pennsylvania 18104 (US)
(74) Representative: Johnston, Kenneth Graham

(56) References cited:
- US-A- 4 657 628
- US-A- 4 690 730
- US-A- 4 940 509

## Description

### Background of the Invention

The present invention relates to integrated circuits and methods for manufacturing them.

Those concerned with the development of integrated circuits have continually sought new methods and structures for reducing the resistivity of contacts to the source, gate and drain of individual transistors as well as reducing the resistivity of interconnections between transistors. Various refractory metal silicides have become popular in integrated circuit design because of their low resistivity, stability, and capability for self-aligned formation.

Titanium silicide has recently become popular in VLSI applications. In a typical self-aligned titanium silicide process, a layer of titanium film is deposited after the gates and sources and drains have been formed. The titanium is reacted with the silicon on the source/drains, and the gate polysilicon, thus forming titanium silicide. Usually an oxide spacer adjacent the gate stack prevents bridging between the source or drain and the gate because the titanium does not react well with silicon dioxide. (Other silicides may be formed by similar processes.)

A typical titanium silicide formation process will now be examined in greater detail. An approximately 100 nanometers thick titanium film is deposited by evaporation or sputtering over a partially fabricated integrated circuit. The circuit has exposed silicon and polysilicon surfaces (which will eventually react with the titanium) and silicon dioxide or other substances (which do not, desirably, react with the titanium.) Next, if desired, a silicon implant may be directed through the titanium. The silicon implant slightly damages the underlying silicon or polysilicon substrate and ensures a more consistent formation of titanium silicide. Then the titanium is reacted with the underlying silicon or polysilicon by heating. The heating may be accomplished in a conventional furnace or it may be accomplished by Rapid Thermal Annealing (RTA), also termed Rapid Thermal Processing (RTP).

The heating process proceeds in a nitrogen atmosphere. It is desirable that oxygen be excluded, since it has been found that the presence of oxygen during the reaction promotes the formation of titanium oxides. Titanium oxides are insulators, and their presence dramatically increases the resistivity of the resulting silicide layers. The increased resistivity is undesirable. The presence of the nitrogen ambient in the above process inherently grows a titanium nitride cap with the uppermost portion of the titanium metal layer.

After the above-mentioned heating step, an etch with hydrogen peroxide and phosphoric acid is performed to remove the thin nitride cap and any unreacted titanium. Finally, a second heating step is performed to change the phase of the titanium silicide to a phase with lower resistivity.

As mentioned before, tile problem of oxygen contamination in the nitrogen atmosphere used for the silicide reaction process is a serious one. One approach to preventing oxygen contamination is illustrated in U.S. Patent No. 4. 690,730, issued to Tang et al. The Tang et al. patent teaches the deposition of a cap of silicon dioxide or a cap of silicon dioxide, with an upper layer of titanium nitride or silicon nitride, prior to the first heating step. The cap layer prevents the aforementioned undesirable oxygen contamination.

### Summary of the Invention

Applicants have discovered that removing an oxide cap, as described above, can present problems. Those etchants and etching procedures which remove the oxide also tend to attack the underlying silicide. Thus, the resistivity of the silicide and the final silicide layer thickness may be adversely affected by the very process designed to protect it.

The present invention provides a protective cap for the silicide which may be removed (where desired) without significant risk of damage to the underlying silicide. The protective cap in one illustrative embodiment is made from titanium nitride which is formed prior to the first heating step that forms the silicide. The cap serves to prevent oxygen contamination during the first heating step.

In addition, applicants have found that the conventional Rapid Thermal Annealing process does not heat the wafer entirely uniformly. Consequently, integrated circuits in one portion of the wafer receive more heat than integrated circuits in another portion of the wafer. Since the first heating step governs silicide thickness, integrated circuits in one portion of the wafer may receive a thicker silicide layer than integrated circuits in another portion of the wafer. The present invention, in an illustrative embodiment, also helps reduce the variation in resistance by making it more likely that all of the metal which is deposited is engaged in reaction with the underlying silicon or polysilicon. In some embodiments of the present invention, the protective cap is removed after silicide formation. In other embodiments, the protective cap remains in place to serve as an electrical conductor.

### Brief Description of the Drawing

Figs 1-5 are cross-sectional views of a portion of an integrated circuit. The views illustrate the process of the present invention.

Fig 6 is a partial cross-sectional and partial perspective view of an integrated circuit utilizing aspects of the present invention.

### Detailed Description

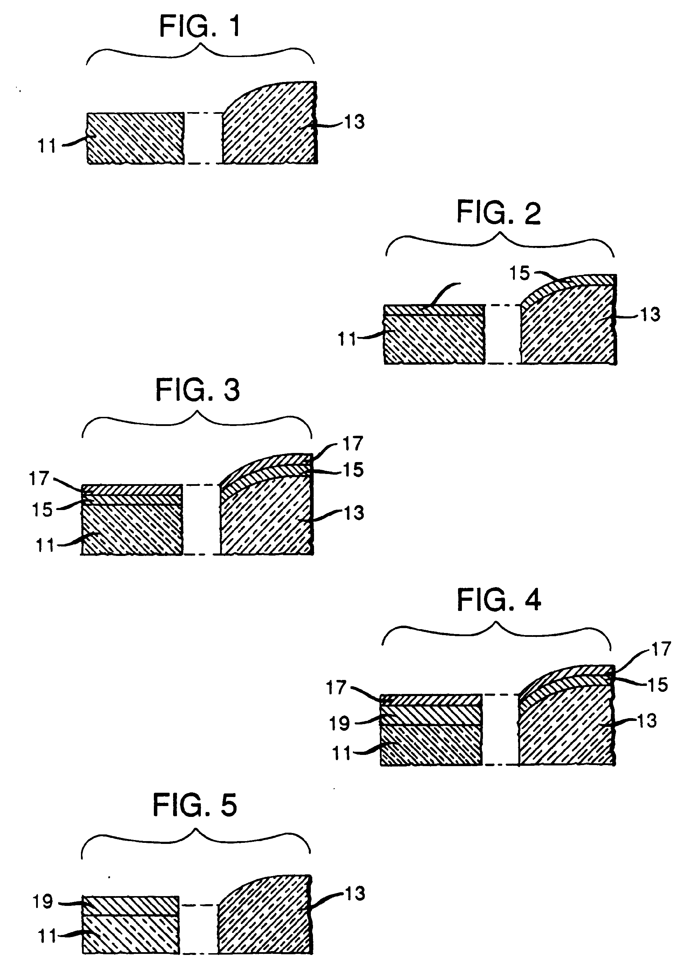

Figure 1 is a cross sectional view of a portion of an integrated circuit during processing. Of course, the Figure is not drawn to scale and individual layers are not drawn in relative proportion so that the invention may be more easily understood. The details of individual transistors have been omitted in the interests of both clarity and generality. Reference numeral 11 denotes a silicon region upon which a silicide may be formed. Reference numeral 11 may denote a silicon substrate, or deposited epitaxial silicon, or polysilicon, which may be either doped or undoped. Reference numeral 13 denotes a material region which does not form a silicide, such as silicon dioxide.

Reference numeral 11 might be, for example, the source or drain region of a transistor. Reference numeral 11 might also denote a polysilicon layer on top of a gate oxide, the pair of layers constituting the gate stack of a transistor. Alternately, reference numeral 11 might denote a polysilicon runner. Reference numeral 13 might denote a field oxide formed by any of a variety of processes known to those skilled in the art. Alternatively, reference numeral 13 might denote a gate spacer.

Turning to Fig. 2, reference numeral 15 denotes a layer of a refractory metal, preferably titanium. Layer 15 is deposited both upon region 11 and region 13. The thickness of layer 15 is typically between 20 nanometers and 80 nanometers, and, preferably, about 40 nanometers in one current process. The amount of metal deposited in the inventive process is typically less than the amount of metal deposited in conventional siliciding processes and less than the amount mentioned in the Tang et al. patent above (100 nanometers). This reduced thickness in the inventive process allows for complete reaction of the metal that is deposited on the silicon region 11.

During investigation of the mechanics of the conventional siliciding process, the inventors discovered that when 100 nanometers of metal was deposited, amounts ranging from approximately 40 nanometers to 60 nanometers were reacted with the underlying silicon region. The amount of reacted metal depended upon the amount of heat experienced at the reaction site. Since the Rapid Thermal Annealing (RTA) process did not provide a sufficiently uniform heating of the wafer surface, some integrated circuits had thicker silicides than others. Those circuits with thicker silicides exhibited somewhat lower resistivity. A study of the resistivities of silicides formed on various portions of a test wafer showed an approximate 11 percent variation in resistivity, depending upon location of the silicide on the wafer.

In the conventional process, the unreacted titanium is later etched away. In the present inventive process preferably all of the titanium deposited on the silicon regions are reacted.

Turning to Fig. 3, protective cap 17 is formed over metal layer 15. If metal layer 15 is titanium, cap 17 is preferably titanium nitride. Layer 17 may be reactive sputter deposited from a titanium target in a nitrogen ambient. Alternatively, layer 17 may be sputter-deposited from a composite titanium nitride target in an inert atmosphere. Layer 17 prevents oxygen contamination during the subsequent heating step. Layer 17 has a thickness preferably between 30 nanometers and 80 nanometers. As an alternative to titanium nitride, silicon nitride may be used. The silicon nitride may be sputter-deposited or deposited in a plasma-enhanced vapor deposition process. The silicon nitride will also prevent oxygen contamination. (As will be mentioned subsequently, the silicon nitride layer may be later etched away in hot phosphoric acid, or other suitable wet or dry etchants.)

During investigation of the mechanics of the conventional siliciding process (without the cap layer 17) it was found that a thin (approximately 15 nanometers) layer of titanium nitride forms over the titanium during the first (i.e., silicidation) rapid thermal annealing step. As the thermal annealing progresses, three competing reactions occur. Titanium and silicon react to form titanium silicide near the titanium/silicon interface. Residual oxygen in the heating system penetrates the upper surface of the titanium and proceeds inward until it meets the silicide, undesirably increasing the resistivity of the resulting layer. In addition, nitrogen penetrates the upper surface of the titanium, forming titanium nitride. However, because of the self-limiting diffusion of nitrogen in titanium nitride, the titanium nitride remains principally on the outer surface of the structure. Thus, the resulting structure is sandwich-like with a layer of oxygen contaminated titanium silicide followed by a layer of unreacted titanium and covered by a thin layer of titanium nitride. As mentioned before, the final thickness of the titanium silicide depends upon the heating temperature.

Unfortunately the titanium nitride formed during the first heating step in the conventional process does not prevent oxygen intrusion into the titanium metal. In the present invention, a thicker titanium nitride cap is separately formed prior to the heating step. This separately-formed cap serves to protect the underlying metal from oxygen penetration during the subsequent heating step.

Returning to Fig. 3, after layer 17 is deposited, an optional silicon implant with a typical dose of between 1 x 10¹⁵ ions/cm² and 3 x 10¹⁵ ions/cm², preferably 1 x 10¹⁵ ions/cm², at an energy of approximately 110 kev, is performed through layers 17 and 15. The implant serves to mix the titanium/silicon interface, thus promoting more effective silicidation during the next heating step (which is performed to reduce the resistivity of the silicide). (If desired, the silicon implantation may be performed prior to the titanium nitride deposition.)

Fig. 4 is illustrative of what happens during the next step. The wafer is subjected to a Rapid Thermal Annealing in a nitrogen atmosphere at a temperature typically between 600°C and 660°C for a period of time between 20 and 120 seconds. In a typical RTA process, the temperature is increased by roughly 50°C per second (typically by means of flash lamps) up to the specified annealing temperature where it is held for the specified period of time. The wafer is then allowed to cool. The present invention eliminates an hitherto unrealized disadvantage of the increasingly popular RTA conventional processes. These processes have been employed for both the first and second heating steps in an effort to eliminate the possibility of undesirable oxygen contamination experienced during conventional furnace heating. However, as mentioned before, much of the equipment in current use does not provide completely uniform heating across the face of the wafer. Some portions of the wafer surface receive slightly more heat than others. Unfortunately, the amount of heat experienced by any given portion of the wafer determines the amount of titanium which will react with the underlying silicon or polysilicon. Consequently, integrated circuits of one portion of the wafer have thicker silicides than integrated chips on another portion of the wafer. The variation in silicide thickness causes a variation in resistivity in contacts and interconnections.

Efforts are underway in the semiconductor industry to develop Rapid Thermal Annealing equipment which provides more uniform wafer heating. The present invention will, nevertheless, find applicability even in improved Rapid Thermal Annealing equipment because of the oxygen contamination problem.

As mentioned before, layer 17 protects the underlying silicide 19 from oxygen intrusion during its formation. In a typical reaction, with 40 nanometers of titanium deposited, approximately 90 nanometers of silicon will be consumed to produce approximately 100 nanometers of titanium silicide 19. All of the titanium in the typical reaction in the regions 11 is consumed. Consequently, the thickness of the silicide regions will be comparatively uniform across the face of the wafer.

In experiments performed to test the inventive process, a variation of silicide thickness of roughly one percent was observed when various sites on the face of a test wafer were examined. By contrast, as mentioned before, a variation in thickness of as much as eleven percent has been observed when using the conventional process.

It may be noted when examining Fig. 4 that layers 15 and 13 do not exhibit any siliciding reaction.

Turning now to Fig. 5, protective cap 17 has been removed from the upper surface of the wafer. An etch with phosphoric acid and hydrogen peroxide for approximately nine minutes at approximately 80°C may be used to remove the titanium nitride layer 17. Alternatively, etches with sulfuric acid and hydrogen peroxide or with ammonia and hydrogen peroxide may he used. If cap 17 is silicon nitride, it may be removed with hot phosphoric acid. Unreacted titanium layer 15 is also typically removed by the same etching process.

By contrast, in the above-mentioned Tang et al. patent, a oxide cap layer is in direct contact with the surface of the titanium silicide. Applicants' investigations have shown that it is difficult to etch away the oxide layer without risk of some damage to the underlying titanium silicide. In that case, the damaged or thinned titanium silicide will exhibit greater resistivity, and will be more likely damaged by subsequent etching. For example, if the silicide is formed over a source or drain region and the above-mentioned thinning occurs, a subsequent window etching process may farther damage or thin the silicide. Later metal contacts may then show undesirable high resistance.

Finally, a second Rapid Thermal Annealing is performed at a temperature typically between 800°C and 950°C, for a time between 10 sec and 60 sec. The second RTA step converts the titanium silicide layer formed during the first RTA step to a more conductive phase. Specifically, the first RTA step creates titanium silicide in a high-resistivity phase (termed C-49 by those skilled in the art). The second RTA step converts the high-resistivity phase to a low resistivity phase (termed C-54 by those skilled in the art).

With modern wafer-processing machinery, the titanium layer 15 and titanium nitride layer 17 may be deposited in the same machine, if desired. An example of such a machine is Varian's 3180 machine. (By contrast, the oxide cap technique typically requires a separate apparatus for silicon dioxide deposition.)

In general, the layer 15 need not be pure titanium. Instead it may be any one of a wide range of titanium alloys or pseudo alloys, as long as their chemistry is dominated by titanium, including compositions of titanium-vanadium, titanium-aluminum, titanium-tungsten, and titanium-yttrrium.

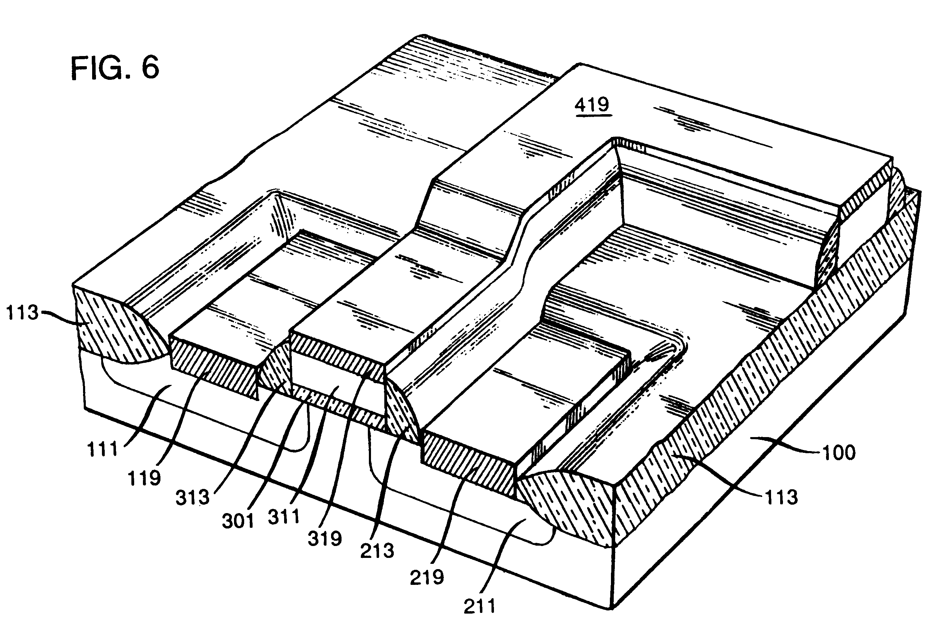

Fig 6 provides an illustration of application of the inventive process to a typical MOS transistor structure. Reference numeral 100 denotes a substrate which may be single-crystal silicon or epitaxial silicon deposited thereon. Doped regions 111 and 211 form the source and drain of a transistor. Reference numeral 301 denotes a gate oxide, and reference numeral 311 denotes a polysilicon layer above oxide 301. A field oxide is denoted by reference numeral 113. Oxide gate spacers are denoted by reference numerals 213 and 313. Silicide regions 119 and 219 may be formed over doped regions 111 and 211, respectively, by the inventive process. Also, silicide region 319 may be formed over polysilicon gate layer 311. Furthermore, silicide region 319 may he extended to runner 419.

Furthermore, although Fig 6 depicts only a gate-level runner 419, the inventive process may be applied to create higher level runners, if so desired. Hence, the inventive process is not limited to salicide processes; rather, it may be applied to silicide-forming processes on any level. For example, should a silicided runner be desired for a higher level interconnection, a layer of polysilicon might be deposited over a dielectric layer, typically silicon dioxide. The polysilicon might then be covered with a layer of metal, such as titanium. Then, per the inventive process, a layer of titanium nitride may be formed to cover the titanium). Next, the aforementioned first heating step may be performed to react the metal, forming a silicide. The silicide/nitride stack may then be patterned to form runners. (Alternately, the metal-polysilicon stack could be first patterned and then reacted to form the silicide.) Finally, the second heating step may be performed to reduce the silicide resistivity. The conductive titanium nitride may, if desired, remain in place on top of the silicide runner.

The inventive concept may also be extended to take advantage of the conductive properties of titanium nitride and its use as a local interconnection. For example, returning to the discussion of Fig. 4, after silicide 19 has been formed over region 11, it has been noted that titanium layer 15 has not reacted with substrate 13. Portions of titanium layer 15 and overlying titanium nitride cap layer 17 may be covered with a mask, if desired, before portions of titanium nitride layer 17 covering silicide 19 are etched away. The mask may contain an interconnection pattern which, for example, might extend from the source of one transistor to the gate and/or drain of other transistors. The mask may be removed before the second heating step, which changes silicide 19 from a high resistivity phase to a low resistivity phase. The resulting local interconnect has titanium metal 15 covered by titanium nitride 17 extending over region 13.

Should this local interconnection process be utilized, it may be desirable to form a titanium nitride layer 17 having a thickness greater than the illustration values noted above, so that the resistivity of the local interconnection is made low. A thickness of as much as 160 nanometers for layer 17 may be desirable to provide less than 3 ohm per square sheet resistance.

Other refractory metal silicides, such as those formed with tungsten, tantalum, and molybdenum, may advantageously employ the teachings of the present invention, especially with a silicon nitride protective cap.

## Claims

1. A method for fabricating integrated circuit devices by providing a substrate having thereon a partially fabricated integrated circuit structure, including at least one portion comprising silicon, and forming a refractory metal silicide on said one portion; whereby said forming is accomplished by depositing on said structure a metallic layer comprising said refractory metal; a cap layer is deposited comprising a nitride of metal or of silicon on the top surface of said metallic layer; and heat is applied to react the metallic layer that overlies said portion of silicon.

2. The method of claim 1 wherein said refractory metal is titanium.

3. The method of claim 1 further including the additional step of removing at least portions of said cap layer.

4. The method of claim 3 further including an additional heating step performed after removal of said cap layer, in order to reduce the resistivity of said silicide.

5. The method of claim 3 wherein said heating step is performed by Rapid Thermal Anneallng.

6. The method of claim 4 wherein said additional heating step is performed by Rapid Thermal Anneallng.

7. A method for fabricating integrated circuit devices comprising the steps of: providing a substrate having thereon a partially fabricated integrated circuit structure, including exposed portions comprising silicon; and depositing an overall layer of a metal comprising titanium, said layer having a thickness between 20 nanometers and 80 nanometers; forming by sputtering a cap layer comprising titanium nitride on top of said metal layer, said cap layer having a thickness between 30 nanometers and 80 nanometers; performing a silicon implantation directed through said metal layer and said cap layer into said formerly exposed portion of silicon; heating said layers by Rapid Thermal Annealing at a temperature between 600°C and 660°C to react all of said metal layer with said silicon, forming titanium silicide; removing said cap layer by etching with hydrogen peroxide and a material chosen from the group consisting of phosphoric acid, sulfuric acid and ammonia; and heating said titanium silicide by Rapid Thermal Anneallng at a temperature between 800°C and 950°C.

## Patentansprüche

1. Verfahren zum Herstellen integrierter Schaltungseinrichtungen mittels Bereitstellen eines Substrats, an welchem sich eine teilweise hergestellte integrierte Schaltungsstruktur befindet, die wenigstens einen Silizium enthaltenden Abschnitt umfasst, und Ausbilden eines Silizids eines hochschmelzenden Metalls an dem einen Abschnitt, wobei das Ausbilden durch Abscheiden einer metallischen Schicht an der Struktur, die das hochschmelzende Metall enthält, erreicht wird, wobei an der oberen Oberfläche der metallischen Schicht eine Abdeckschicht mit einem Nitrid von einem Metall oder von Silizium abgeschieden wird, und wobei Wärme aufgebracht wird, um die metallische Schicht, die über dem Abschnitt aus Silizium liegt, reagieren zu lassen.

2. Verfahren nach Anspruch 1, in welchem das hochschmelzende Metall Titan ist.

3. Verfahren nach Anspruch 1, ferner umfassend den zusätzlichen Schritt des Entfernens wenigstens von Anteilen der Abdeckschicht.

4. Verfahren nach Anspruch 3, ferner umfassend einen zusätzlichen Erhitzungsschritt, der nach dem Entfernen der Abdeckschicht durchgeführt wird, um den spezifischen Widerstand des Silizids zu senken.

5. Verfahren nach Anspruch 3, in welchem der Schritt des Erhitzens durch schnelles thermisches Annealen durchgeführt wird.

6. Verfahren nach Anspruch 4, in welchem der zusätzliche Schritt des Erhitzens durch schnelles thermisches Annealen durchgeführt wird.

7. Verfahren zur Herstellung integrierter Schaltungseinrichtungen mit den Schritten: Bereitstellen eines Substrats mit einer teilweise hergestellten integrierten Schaltungsanordnung daran, umfassend freigelegte Silizium enthaltende Abschnitte, und Abscheiden einer Gesamtschicht aus einem Metall mit Titan, wobei die Schicht eine Dicke zwischen 20 und 80 Nanometer hat, Ausbilden einer Titannitrid enthaltenden Abdeckschicht oberhalb der Metallschicht durch Sputtern, wobei die Abdeckschicht eine Dicke zwischen 30 Nanometer und 80 Nanometer hat, Durchführen einer Siliziumimplantation, die durch die Metallschicht und die Abdeckschicht in den vorher freiliegenden Abschnitt von Silizium durchgeführt wird, Erhitzen der Schichten durch schnelles thermisches Annealen bei einer Temperatur zwischen 600°C und 660°C, um die gesamte Metallschicht mit dem Silizium reagieren zu lassen, Ausbilden von Titansilizid, Entfernen der Abdeckschicht durch Ätzen mit Wasserstoffperoxid und einem Material, das aus der Gruppe ausgewählt ist, die Phosphorsäure, Schwefelsäure und Ammoniak enthält, und Erhitzen des Titansilizids mit schnellem thermischen Annealen bei einer Temperatur zwischen 800°C und 950°C.

## Revendications

1. Procédé pour fabriquer des dispositifs à circuits intégrés en fournissant un substrat supportant une structure de circuit intégré partiellement fabriquée, comportant au moins une partie comprenant du silicium, et en formant un siliciure d'un métal réfractaire sur ladite partie, étant entendu que la formation est effectuée par dépôt sur ladite structure d'une couche métallique comprenant ledit métal réfractaire, qu'une couche de recouvrement contenant un nitrate d'un métal ou de silicium est déposée sur le dessus de ladite couche métallique et que de la chaleur est appliquée afin de faire réagir la couche métallique qui recouvre ladite partie de silicium.

2. Procédé selon la revendication 1, dans lequel ledit métal réfractaire est du titane.

3. Procédé selon la revendication 1, comprenant, en outre, une étape supplémentaire consistant à enlever au moins des parties de ladite couche de recouvrement.

4. Procédé selon la revendication 3, comprenant, en outre, une étape supplémentaire de chauffage réalisée après l'enlèvement de ladite couche de recouvrement dans le but de diminuer la résistivité dudit siliciure.

5. Procédé selon la revendication 3, dans lequel ladite étape de chauffage est réalisée par recuit thermique rapide.

6. Procédé selon la revendication 4, dans lequel ladite étape supplémentaire de chauffage est réalisée par recuit thermique rapide.

7. Procédé pour fabriquer des dispositifs à circuits intégrés comportant les étapes suivantes: fourniture d'un substrat supportant une structure de circuit intégré partiellement fabriquée, comportant des parties exposées comprenant du silicium; et dépôt d'une couche globale d'un métal comprenant du titane, ladite couche ayant une épaisseur comprise entre 20 nanomètres et 80 nanomètres; formation par pulvérisation cathodique d'une couche de recouvrement comprenant du nitrure de titane par-dessus ladite couche de métal, ladite couche de recouvrement ayant une épaisseur comprise entre 30 nanomètres et 80 nanomètres; réalisation d'une implantation de silicium à travers ladite couche de métal et ladite couche de recouvrement dans ladite partie de silicium précédemment exposée; chauffage desdites couches par recuit thermique rapide à une température de l'ordre de 600°C à 660°C afin de faire réagir la totalité de ladite couche de métal avec ledit silicium, en vue de former du siliciure de titane; enlèvement de ladite couche de recouvrement par attaque chimique au peroxyde d'hydrogène et une matière choisie dans le groupe constitué par l'acide phosphorique, l'acide sulfurique et l'ammoniaque; et chauffage dudit siliciure de titane par recuit thermique rapide à une température comprise entre 800°C et 950°C.
